# EUROPEAN PATENT APPLICATION

(11) **EP 4 478 384 A1**
(43) Date of publication of application: **18.12.2024**
(21) Application number: 22925836.3
(22) Date of filing: 09.02.2022
(51) Int. Cl.: H01F 10/08, H10N 52/00, H10N 50/10, H01L 29/82, G01R 33/09

(54) **SENSOR ELEMENT AND METHOD FOR MANUFACTURING SAME**

(71) Applicant: TDK Corporation, Tokyo 103-6128 (JP)
(72) Inventor: KUROKI, Koji, Tokyo 103-6128 (JP); SHIMURA, Shigeru, Tokyo 103-6128 (JP)
(74) Representative: Epping - Hermann - Fischer
(86) International application number: PCT/JP2022/005043
(87) International publication number: WO 2023/152814

(57) **Abstract**

To reliably electrically connect the lead layer and protective film that covers a functional film even when the film thickness of the protective film is very small. After formation of a conductive protective film 51 on the surface of a functional film 20, reverse sputtering is performed with a part of the surface of the protective film 51 covered with a mask 60 to physically reduce a native oxide film 52 formed on a part of the surface of the protective film 51 that is not covered with the mask 60. Thereafter, a lead layer 40 is formed on a part of the surface of the protective film 51 that is not covered with the mask 60. This can remove the native oxide film 52 formed on the protective film 51 without requiring etching. Thus, even when the film thickness of the protective film 51 is very thin, it is possible to electrically connect the lead layer 40 and protective film 51 without damaging the functional film 20.

## Description

### [Technical Field]

The present invention relates to a sensor element and a manufacturing method therefor and, more particularly, to a sensor element having a conductive protective film that covers the surface of a functional film and a manufacturing method therefor.

### [Background Art]

Patent Document 1 discloses a GMR element covered with a protective film made of Ta or the like. Here, it is known that a native oxide film is formed on the surface of metal such as Ta. Thus, when a lead layer for voltage application to a functional film constituting a GMR element or the like is formed on the surface of a protective layer such as Ta, it is necessary to, ahead of time, remove the native oxide film formed on the surface of the protective film.

### [Citation List]

### [Patent Document]

[Patent Document 1] Japanese Patent No. 5,971,681

### [Disclosure of the Invention]

### [Problem to be Solved by the Invention]

However, when the film thickness of the protective film is very small, it is difficult to etch (remove) the native oxide film while leaving the protective film. More specifically, in this case, excessive etching completely removes the protective film at the etched portion to subject the functional film to etching; on the other hand, insufficient etching leaves the native oxide film to result in an increase in resistance value between the lead layer and the protective film.

It is therefore an object of the present invention to reliably electrically connect the lead layer and the protective film that covers a functional film even when the film thickness of the protective film is very small.

### [Means for Solving the Problem]

A sensor element according to the present invention includes: a conductive functional film whose electrical characteristics vary based on a predetermined physical amount to be detected; a conductive protective film covering the surface of the functional film; and a lead layer applying a voltage to the functional film through the protective film. The protective film has a connected area covered with the lead layer and a non-connected area not covered with the lead layer. The surface of the non-connected area of the protective film is covered with an insulating film, while the surface of the connected area of the protective film contacts the lead layer without being covered with an insulating film. The thickness of the protective film in the connected area is larger than the thickness of the protective film in the non-connected area.

According to the present invention, a sufficient thickness of the protective film in the connected area is ensured, so that even when the film thickness of the protective film that covers the functional film is very small, the lead layer and protective film can be reliably electrically connected.

In the present invention, the insulating film may be a native oxide film formed by oxidation of the surface of the protective film. Since the native oxide film is not interposed between the lead layer and the protective film, a resistance value therebetween can be sufficiently reduced.

In the present invention, the protective film may be a single film. This allows the protective film to be formed in a single process.

In the present invention, the functional film may constitute a part of a magnetoresistive effect element whose resistance value varies based on a magnetic field and have first and second element pieces, between which a hard magnetic body that applies a magnetic bias to the functional film may be provided. The lead layer may electrically connect the first and second element pieces by covering the surface of the hard magnetic body, the connected area of the first element piece, and the connected area of the second element piece. This can reduce irregular noise of the magnetic sensor.

A sensor element manufacturing method according to the present invention includes: a first step of forming a conductive functional film whose electrical characteristics vary based on a predetermined physical amount to be detected; a second step of forming a conductive protective film on the surface of the functional film; a third step of partially covering the surface of the protective film with a mask; a fourth step of physically reducing a native oxide film formed on a part of the surface of the protective film that is not covered with the mask by performing reverse sputtering through the mask; and a fifth step of forming, after the fourth step, a lead layer in the connected area of the protective film that is not covered with the mask.

According to the present invention, the native oxide film formed on the surface of the protective film can be removed without requiring etching, so that even when the film thickness of the protective film is very small, it is possible to electrically connect the lead layer and protective film without damaging the functional film.

In the present invention, the fourth and fifth steps may be successively performed without exposure to the atmosphere. This prevents the native oxide film from being formed again on the surface of the protective film that has been physically reduced.

### [Advantageous Effects of the Invention]

As described above, according to the present invention, the lead layer and protective film can be reliably electrically connected even when the film thickness of the protective film that covers the functional film is very small.

### [Brief Description of the Drawings]

[FIG. 1]

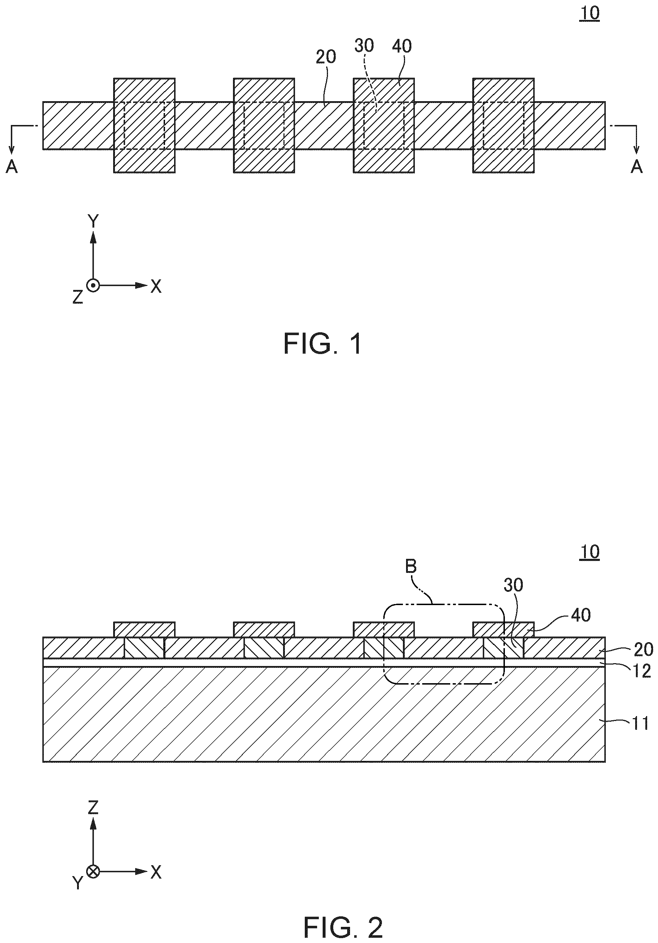

   FIG. 1 is a schematic plan view for explaining the structure of a sensor element 10 according to an embodiment of the present invention.
[FIG. 2]
   FIG. 2 is a schematic cross-sectional view taken along the line A-A illustrated in FIG. 1.
[FIG. 3]

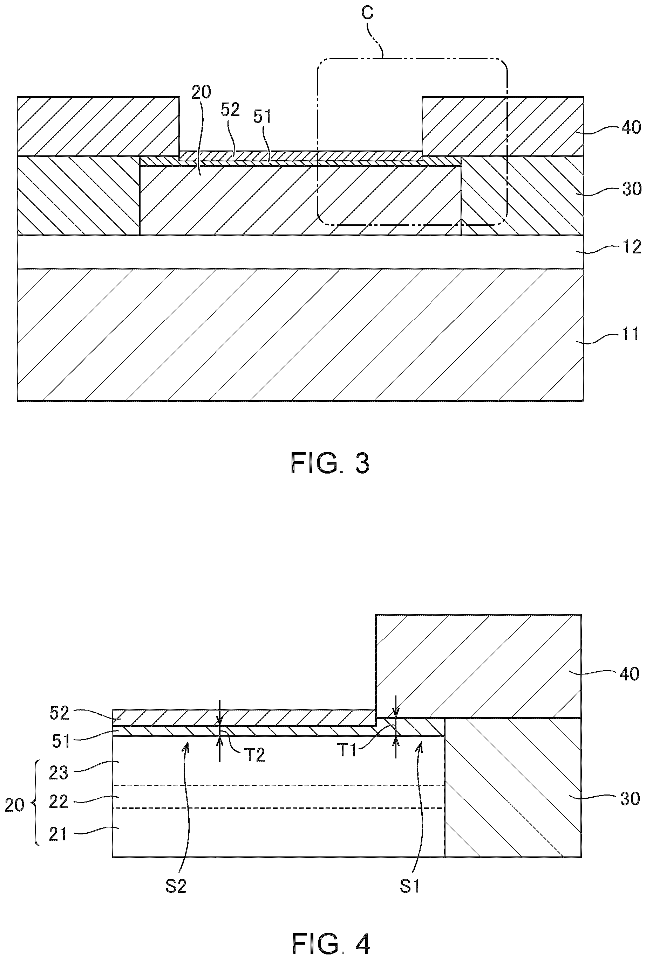

   FIG. 3 is a schematic enlarged cross-sectional view of an area B illustrated in FIG. 2.
[FIG. 4]
   FIG. 4 is a schematic enlarged cross-sectional view of an area C illustrated in FIG. 3.
[FIG. 5]

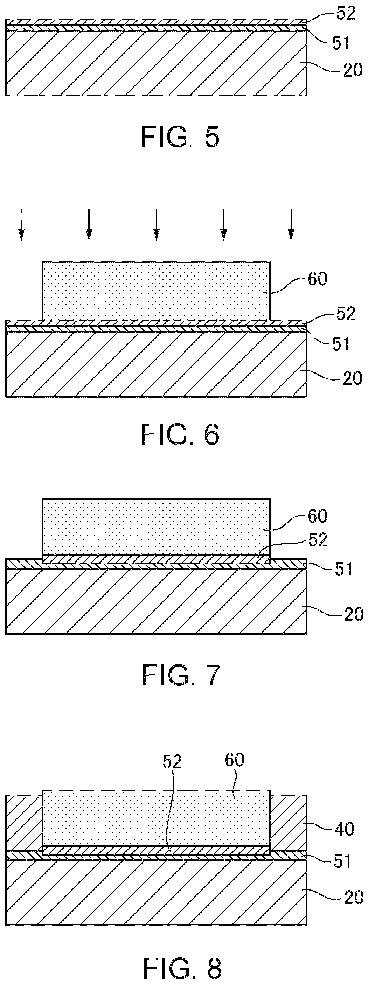

   FIG. 5 is a process view for explaining a manufacturing method for the sensor element 10.
[FIG. 6]
   FIG. 6 is a process view for explaining a manufacturing method for the sensor element 10.
[FIG. 7]
   FIG. 7 is a process view for explaining a manufacturing method for the sensor element 10.
[FIG. 8]
   FIG. 8 is a process view for explaining a manufacturing method for the sensor element 10.

### [Mode for Carrying Out the Invention]

Hereinafter, preferred embodiments of the present invention will be described in detail with reference to the accompanying drawings.

FIG. 1 is a schematic plan view for explaining the structure of a sensor element 10 according to an embodiment of the present invention. FIG. 2 is a schematic cross-sectional view taken along the line A-A illustrated in FIG. 1.

The sensor element according to the present embodiment is a magnetic sensor for detecting a magnetic field and includes, as illustrated in FIGS. 1 and 2, a functional film 20 and a hard magnetic body 30 which are alternately arranged in the X-direction and a lead layer 40 electrically connecting two element pieces of the functional film 20 adjacent in the X-direction. The functional film 20 and hard magnetic body 30 are formed on a sensor substrate 11 through an insulating film 12. The functional film 20 is a magnetoresistive effect element whose resistance value varies based on the direction and strength of a magnetic field and is substantially sectioned into single magnetic domains by a magnetic bias applied by the hard magnetic body 30. This reduces irregular noise caused due to disturbance of the magnetic domain. The magnetic sensing direction of the functional film 20 is the Y-direction, for example. The hard magnetic body 30 is formed of a material having a high resistance value. The lead layer 40 covers the surface of the hard magnetic body 30 and further covers one end portion of each of the two element pieces of the functional film 20 that sandwich the hard magnetic body 30 to electrically connect the two element pieces of the functional film 20 adjacent in the X-direction. Thus, the resistance value of a magnetoresistive strip constituted by a plurality of the element pieces of the functional film 20 arranged in the X-direction varies in accordance with magnetic field strength in the Y-direction, for example. This makes it possible to detect a magnetic field by applying a voltage to the magnetoresistive strip through the lead layer 40.

FIG. 3 is a schematic enlarged cross-sectional view of an area B illustrated in FIG. 2.

As illustrated in FIG. 3, the surface of the functional film 20 is covered with a protective film 51. The protective film 51 is provided for protecting the functional film 20 and is formed of a conductive material excellent in cost performance and solvent resistance and high in resistance value, such as Ta, Ti, or nichrome. The protective film 51 formed of such a conductive material is easily oxidized in the atmosphere, and thus a native oxide film 52 is formed on a part of the surface of the protective film 51 that is not covered with the lead layer 40.

FIG. 4 is a schematic enlarged cross-sectional view of an area C illustrated in FIG. 3.

In the example illustrated in FIG. 4, the functional film 20 includes a pin layer 21, a nonmagnetic layer 22, and a free layer 23, and the surface of the free layer 23 is covered with the protective film 51. With this configuration, the functional film 20 functions as a GMR element. The protective film 51 is not uniform in thickness, and assuming that the thickness thereof in a connected area S1 covered with the lead layer 40 is T1 and that the thickness of a non-connected area S2 not covered with the lead layer 40 is T2, T1 > T2 is satisfied. The surface of the non-connected area S2 of the protective film 51 is covered with the native oxide film 52, while the surface of the connected area S1 of the protective film 51 is not covered with the native oxide film 52 but contacts the lead layer 40 directly or through an adhesion layer such as Ti. The protective film 51 differs in thickness depending on the plane position but is a single film formed through a single film formation process.

As described above, according to the sensor element 10 according to the present embodiment, the thickness T1 of the protective film 51 in the connected area S1 covered with the lead layer 40 is sufficiently ensured, and the lead layer 40 and the protective film 51 are not insulated by the native oxide film 52, so that it is possible to apply a voltage to the functional film 20 from the lead layer 40 through the protective film 51 while reliably protecting the functional film 20. Note that another insulating film formed by subsequent chemical treatment may exist on the surface of the native oxide film 52 formed in the non-connected area S2.

The following describes a manufacturing method for the sensor element 10 according to the present embodiment.

FIGS. 5 to 8 are process views for explaining a manufacturing method for the sensor element 10 according to the present embodiment.

First, as illustrated in FIG. 5, after formation of the functional film 20, the protective film 51 is formed on the surface of the functional film 20 by a sputtering method or the like. Although the surface of the protective film 51 is exposed immediately after film formation, the native oxide film 52 is formed on the surface of the protective film 51 by exposure to the atmosphere outside the sputtering chamber. The film thickness of the protective film 51 immediately after film formation is T1 illustrated in FIG. 4, and the film thickness thereof after formation of the native oxide film 52 is T2 illustrated in FIG. 4.

Subsequently, as illustrated in FIG. 6, a photosensitive resist is formed on the surface of the protective film 51 on which the native oxide film 52 is formed, and a mask 60 is formed through exposure and development. As a result, the protective film 51 is partially covered with the mask 60. In this state, reverse sputtering is performed to physically reduce the native oxide film 52 formed on a part of the surface of the protective film 51 that is not covered with the mask 60. Specifically, sputter gas such as Ar is struck against the native oxide film 52 to beat out oxygen contained in the native oxide film 52. To achieve this, it is necessary to control applied voltage and gas pressure so as to beat out only oxygen atoms without beating out metallic elements contained in the native oxide film 52. As a result, a part of the native oxide film 52 that is not covered with the mask 60 is reduced to the protective film 51 made of metal, as illustrated in FIG. 7.

Subsequently, as illustrated in FIG. 8, the lead layer 40 is formed on a part of the protective film 51 that is not covered with the mask 60 by a sputtering method or the like. As a result, the protective film 51 and lead layer 40 directly contact each other not through the native oxide film 52. An adhesion layer such as Ti may be formed before formation of the lead layer 40. Then, the mask 60 is removed by ashing, whereby the sensor element 10 according to the present embodiment is completed. The physical reduction of the native oxide film 52 by reverse sputtering and subsequent film formation of the lead layer 40 are successively performed without exposure to the atmosphere. Specifically, the reverse sputtering is performed in a chamber for reverse sputtering, and then the obtained structure is transferred to another chamber for film formation of the lead layer 40 while decompression environment is maintained. Alternatively, reverse sputtering and sputtering for formation of the lead layer 40 may be performed successively using the same chamber.

As described above, in the present embodiment, the native oxide film 52 is physically reduced by reverse sputtering, and then the lead layer 40 is formed using the same mask as that used for the physical reduction, thereby allowing close contact between the protective film 51 and the lead layer 40 not through the native oxide film 52. Further, when chemical treatment is performed after formation of the lead layer 40, another insulating film may be formed on the surface of the native oxide film 52; however, at the time point when the lead layer 40 is formed, the connected area S1 of the protective film 51 contacts the lead layer 40, so that such an insulating film is not formed at the boundary between the native oxide film 52 and the protective film 51.

While the preferred embodiment of the present disclosure has been described, the present disclosure is not limited to the above embodiment, and various modifications may be made within the scope of the present disclosure, and all such modifications are included in the present disclosure.

For example, although the present invention is applied to a magnetic sensor in the above embodiment, the applied range of the present invention is not limited to this, but the present invention can widely be applied to any sensor element, such as an infrared sensor or a gyro sensor, that uses a conductive functional film whose electrical characteristics vary based on a predetermined physical amount to be detected.

### [Reference Signs List]

- 10: sensor element
- 11: sensor substrate
- 12: insulating film
- 20: functional film
- 21: pin layer
- 22: nonmagnetic layer
- 23: free layer
- 30: hard magnetic body
- 40: lead layer
- 51: protective film
- 52: native oxide film
- 60: mask
- S1: connected area
- S2: non-connected area

## Claims

1. A sensor element comprising:
a conductive functional film whose electrical characteristics vary based on a predetermined physical amount to be detected;
a conductive protective film covering a surface of the functional film; and
a lead layer applying a voltage to the functional film through the protective film,
wherein the protective film has a connected area covered with the lead layer and a non-connected area not covered with the lead layer,
wherein a surface of the non-connected area of the protective film is covered with an insulating film,
wherein a surface of the connected area of the protective film contacts the lead layer without being covered with an insulating film, and
wherein a thickness of the protective film in the connected area is larger than a thickness of the protective film in the non-connected area.

2. The sensor element as claimed in claim 1, wherein the insulating film is a native oxide film formed by oxidation of a surface of the protective film.

3. The sensor element as claimed in claim 1 or 2, wherein the protective film is a single film.

4. The sensor element as claimed in any one of claims 1 to 3,
wherein the functional film constitutes a part of a magnetoresistive effect element whose resistance value varies based on a magnetic field,
wherein the functional film has first and second element pieces,
wherein a hard magnetic body is provided between the first element piece and the second element piece, the hard magnetic body applying a magnetic bias to the functional film, and
wherein the lead layer electrically connects the first element piece and the second element piece by covering a surface of the hard magnetic body, the connected area of the first element piece, and the connected area of the second element piece.

5. A method for manufacturing a sensor element, the method comprising:
a first step of forming a conductive functional film whose electrical characteristics vary based on a predetermined physical amount to be detected;
a second step of forming a conductive protective film on a surface of the functional film;
a third step of partially covering a surface of the protective film with a mask;
a fourth step of physically reducing a native oxide film formed on a part of the surface of the protective film that is not covered with the mask by performing reverse sputtering through the mask; and
a fifth step of forming, after the fourth step, a lead layer on a connected area of the protective film that is not covered with the mask.

6. The method for manufacturing a sensor element as claimed in claim 5, wherein the fourth and fifth steps are successively performed without exposure to an atmosphere.
